# EUROPEAN PATENT APPLICATION

(11) **EP 4 317 930 A1**
(43) Date of publication of application: **07.02.2024**
(21) Application number: 22774904.1
(22) Date of filing: 25.02.2022
(51) Int. Cl.: G01L 9/06, H01C 10/10, H01C 7/00

(54) **STRAIN RESISTANCE FILM, PRESSURE SENSOR, AND LAYERED BODY**

(30) Priority: 26.03.2021 JP 2021053111
(71) Applicant: TDK Corporation, Tokyo 103-6128 (JP)
(72) Inventor: NAWAOKA, Kohei, Tokyo 103-6128 (JP); UNNO, Ken, Tokyo 103-6128 (JP); SASAHARA, Tetsuya, Tokyo 103-6128 (JP); KOBAYASHI, Masanori, Tokyo 103-6128 (JP)
(74) Representative: Epping - Hermann - Fischer
(86) International application number: PCT/JP2022/008054
(87) International publication number: WO 2022/202106

(57) **Abstract**

[Problem] To provide a distortion resistance film, etc., which includes Cr, Al, and N and in which film separation can be prevented.

[Solution] A distortion resistance film comprising an alloy material including Cr, Al, N, and Si.

## Description

### Technical Field

The present invention relates to a distortion resistance film whose resistance value changes according to distortion, and a pressure sensor using the same.

### Background Art

It has been reported that a material containing Cr, Al, and N exhibits a high gauge factor at -50°C to 300°C including a relatively high temperature region, and is promising as a distortion resistance film. In particular, Patent Literature 1 reports that when a composition range of Al is 4 at% or more and 25 at% or less, such a distortion resistance film can obtain a preferable property not only for the gauge factor but also for a temperature coefficient of sensitivity (TCS).

On the other hand, in a case where a distortion resistance film containing Cr, Al, and N is applied to a pressure sensor or the like, for example, film peeling may occur from an insulating film used as a base film, which is a problem in applying the distortion resistance film containing Cr, Al, and N.

### Citation List

### Patent Literature

PTL1 : JP 2018-91848 A

### Summary of Invention

### Technical Problem

Under such circumstances, the inventors of the present invention have found a distortion resistance film capable of preventing film peeling in a distortion resistance film containing Cr, Al, and N, and have completed the present invention.

The present invention has been made in view of such actual circumstances, and an object of the present invention is to provide a distortion resistance film or the like that contains Cr, Al, and N and can prevent film peeling.

### Solution to Problem

A distortion resistance film according to the present invention includes an alloy material containing Cr, Al, N, and Si.

A distortion resistance including an alloy material containing Cr, Al, N, and Si has a gauge factor capable of detecting resistance change due to distortion, and can prevent a problem of film peeling.

Furthermore, for example, the distortion resistance film according to the present invention, wherein the ally material is represented by a formula Cr_{100-x-y-z}AlₓN_{y}Si_{z}, wherein composition regions of x, y, and z satisfy 5 ≤ x ≤ 50, 1 ≤ y ≤ 20, and 0 < z, respectively.

The distortion resistance film having such a composition range exhibits excellent distortion detection capability due to resistance change from a low temperature of -50°C in a high temperature region of 400°C.

Furthermore, for example, the distortion resistance film according to the present invention, wherein the ally material may be represented by a formula Cr_{100-x-y-z}AlₓN_{y}Si_{z}, wherein composition regions of x, y, and z may satisfy 5 ≤ x ≤ 50, 1 ≤ y ≤ 20, and 0.3 ≤ z ≤ 10, respectively.

Such a distortion resistance film exhibits good distortion detection capability due to resistance change from a low temperature of -50°C in a high temperature region of 400°C, and can effectively prevent the problem of film peeling.

Furthermore, for example, in the distortion resistance film according to the present invention, O may be contained in an amount of 10 at% or less with respect to a total amount of Cr, Al, N, and O.

When O is 10 at% or less, the performance of the distortion resistance film can be improved, for example, in a temperature range of -50°C or more and 400°C or less.

Furthermore, for example, in the distortion resistance film according to the present invention, an absolute value of a temperature coefficient of sensitivity (TCS) may be 2000 ppm/°C or less in a temperature range of -50°C or more and 400°C or less.

Such a distortion resistance film has a sensitivity change per unit temperature change within a predetermined range, and thus can reduce a temperature correction error when used as, for example, a pressure sensor.

Furthermore, for example, in the distortion resistance film according to the present invention, an absolute value of a temperature coefficient of resistance (TCR) may be 2000 ppm/°C or less in a temperature range of -50°C or more and 400°C or less.

Such a distortion resistance film has a resistance value change per unit temperature change within a predetermined range, and thus can reduce a temperature correction error when used as, for example, a pressure sensor.

A pressure sensor according to the present invention includes any one of the distortion resistance films described above, and an electrode portion electrically connected to the distortion resistance film.

The pressure sensor according to the present invention has good durability because it is possible to perform good pressure detection by the distortion resistance film and to prevent the problem of film peeling.

Furthermore, for example, a layered body according to the present invention includes any one of the distortion resistance films described above, and a base insulating layer that is in contact with the distortion resistance film and contains Si.

The layered body according to the present invention can suitably prevent the problem of film peeling between the distortion resistance film and the base insulating layer.

### Brief Description of Drawings

Fig. 1 is a schematic cross-sectional view of a pressure sensor according to an embodiment of the present invention.
Fig. 2 is an enlarged cross-sectional view of a portion indicated by II in Fig. 1.
Fig. 3 is a conceptual diagram illustrating a distortion resistance film according to an example.

### Description of Embodiments

Hereinafter, the present invention will be described based on embodiments illustrated in the drawings.

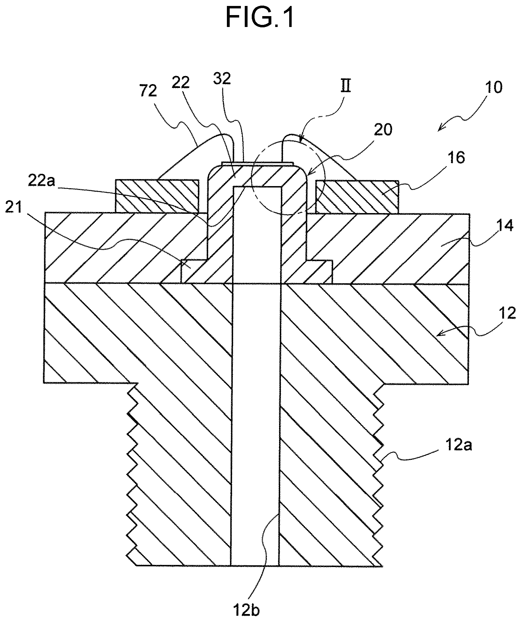

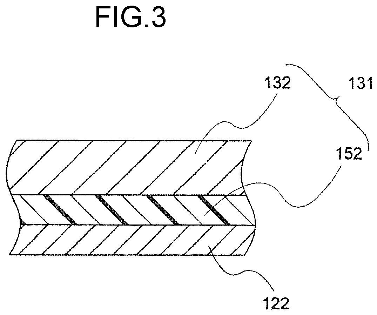

Fig. 1 is a schematic cross-sectional view of a pressure sensor 10 using a distortion resistance film 32 and a layered body 31 including the same according to an embodiment of the present invention. As illustrated in Fig. 1, the pressure sensor 10 includes a membrane 22 that deforms according to pressure. In Fig. 1, the membrane 22 is constituted by an end wall formed at one end of a hollow cylindrical stem 20, but may be constituted by a tabular Si substrate 122 (see Fig. 3) as in the embodiment. The other end of the stem 20 is an open end of a hollow portion, and the hollow portion of the stem 20 communicates with a flow path 12b of a connection member 12.

In the pressure sensor 10, a fluid introduced into the flow path 12b is guided from the hollow portion of the stem 20 to an inner surface 22a of the membrane 22, and a fluid pressure acts on the membrane 22. The stem 20 is made of metal such as stainless steel. However, the shape corresponding to the stem 20 may be configured by processing a silicon substrate by etching, or by bonding a tabular silicon substrate to another material.

A flange portion 21 is formed around the open end of the stem 20 so as to protrude outward from an axis of the stem 20. The flange portion 21 is sandwiched between the connection member 12 and a pressing member 14 so that the flow path 12b leading to the inner surface 22a of the membrane 22 is sealed.

The connection member 12 includes a screw groove 12a for fixing the pressure sensor 10. The pressure sensor 10 is fixed via the screw groove 12a to a pressure chamber or the like in which a fluid to be measured is sealed. As a result, the flow path 12b formed inside the connection member 12 and the inner surface 22a of the membrane 22 in the stem 20 communicate airtightly with the pressure chamber in which the fluid to be measured exists.

A circuit substrate 16 is attached to an upper surface of the pressing member 14. The circuit substrate 16 has a ring shape surrounding a periphery of the stem 20, but the shape of the circuit substrate 16 is not limited thereto. The circuit substrate 16 incorporates, for example, a circuit or the like to which a detection signal from the distortion resistance film 32 is transmitted.

As illustrated in Fig. 1, the distortion resistance film 32 and the like are provided on an outer surface 22b of the membrane 22. The distortion resistance film 32 and the circuit substrate 16 are electrically connected to each other through an intermediate wiring 72 formed by wire bonding or the like.

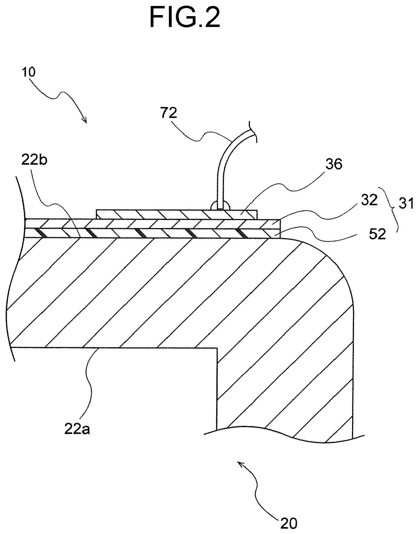

Fig. 2 is a schematic cross-sectional view illustrating a part of the distortion resistance film 32 included in the pressure sensor 10 illustrated in Fig. 1 and its peripheral portion in an enlarged manner.

As illustrated in Fig. 2, the distortion resistance film 32 is provided on the outer surface 22b of the membrane 22 via a base insulating layer 52. The distortion resistance film 32 and the base insulating layer 52 in contact with the distortion resistance film constitute the layered body 31.

The base insulating layer 52 is formed so as to cover substantially the entire outer surface 22b of the membrane 22, is made of, for example, silicon oxide such as SiO₂, silicon nitride, silicon oxynitride, or the like, and contains Si. A thickness of the base insulating layer 52 is preferably 10 µm or less, and more preferably 1 to 5 µm. The base insulating layer 52 can be formed on the outer surface 22b of the membrane 22 by a vapor deposition method such as CVD.

Note that, in a case where the outer surface 22b of the membrane 22 has insulating properties, the distortion resistance film 32 may be formed directly on the outer surface 22b of the membrane 22 without forming the base insulating layer 52. For example, in a case where the membrane 22 is made of an insulating material such as alumina, the distortion resistance film 32 may be directly provided on the membrane 22.

As illustrated in Fig. 2, an electrode portion 36 is provided on the distortion resistance film 32. Although not illustrated, in the distortion resistance film 32, for example, resistors constituting a wheatstone bridge circuit are formed in a predetermined pattern. Since a resistance value of the resistor formed in the distortion resistance film 32 changes according to deformation of the membrane 22, the distortion generated in the membrane 22 and the fluid pressure acting on the membrane 22 are detected from an output of the wheatstone bridge circuit. The distortion resistance film 32 including the resistor can be produced by microfabricating (patterning) a thin film formed to have a predetermined thickness.

Here, the distortion resistance film 32 is made of an alloy material containing Cr, Al, N, and Si. In particular, the distortion resistance film 32 is represented by a general formula Cr_{100-x-y-z}AlₓN_{y}Si_{z}, and composition regions of x, y, and z are preferably 5 ≤ x ≤ 50, 1 ≤ y ≤ 20, and 0 < z, respectively. The distortion resistance film 32 exhibits a good distortion detection capability due to resistance change in a wide temperature region from a low temperature of -50°C to a high temperature region of 400°C by satisfying 5 ≤ x ≤ 50 for x indicating an Al amount, 1 ≤ y ≤ 20 for y indicating a N amount, and 0 < z for z indicating a Si amount in the general formula.

Furthermore, in the distortion resistance film 32, in the general formula described above, it is more preferable that the composition regions of x, y, and z satisfy 5 ≤ x ≤ 50, 1 ≤ y ≤ 20, and 0.3 ≤ z ≤ 10, respectively. When the distortion resistance film 32 has such a composition, film peeling of the distortion resistance film 32 from the base insulating film 32 and the substrate can be suitably prevented. Furthermore, it is possible to achieve both the effect of preventing film peeling by containing Si and good TCR property at a high level.

Furthermore, the distortion resistance film 32 may have an absolute value of a temperature coefficient of resistance (TCR) of2000 ppm/°C or less in a temperature range of -50°C or more and 400°C or less. Since such a distortion resistance film 32 has a small proportion of a resistance value change accompanying a temperature change in a wide range from a low temperature region to a high temperature region, the distortion resistance film is suitably used as the distortion resistance film 32 of the pressure sensor 10 used in a wide temperature range, and can reduce a temperature correction error and perform highly accurate detection.

Furthermore, the distortion resistance film 32 may have an absolute value of a temperature coefficient of sensitivity (TCS) of2000 ppm/°C or less in a temperature range of -50°C or more and 400°C or less. Since such a distortion resistance film 32 has a small proportion of a sensitivity change accompanying a temperature change in a wide range from a low temperature region to a high temperature region, the distortion resistance film is suitably used as the distortion resistance film 32 of the pressure sensor 10 used in a wide temperature range, and can reduce a temperature correction error and perform highly accurate detection.

Furthermore, the distortion resistance film 32 may contain O as an inevitable impurity in an amount of 10 at% or less with respect to a total amount of Cr, Al, N, and O. When O as an inevitable impurity is 10 at% or less, the distortion resistance film 32 can increase the gauge factor in a temperature range of, for example, -50°C or more and 400°C or less.

The distortion resistance film 32 can be formed by a thin film method such as sputtering or vapor deposition by a DC sputtering device or an RC sputtering device. A thickness of the distortion resistance film 32 is not particularly limited, but can be, for example, 1 nm to 1000 nm, and is preferably about 50 nm to 500 nm. O and N contained in the distortion resistance film 32 may be those remaining without being removed from a reaction chamber when the distortion resistance film 32 is formed, and may be taken into the distortion resistance film 32. Furthermore, O and N contained in the distortion resistance film 32 may be introduced into the distortion resistance film 32 while intentionally controlling an introduction amount by being used as an atmospheric gas during film formation or annealing.

The distortion resistance film 32 may contain a metal other than Cr, Al, and Si or a nonmetallic element in a small amount. Examples of metals other than Cr, Al, and Si, and non-metal elements contained in the distortion resistance film 32 include Ti, Nb, Ta, Ni, Zr, Hf, Ge, C, P, Se, Te, Zn, Cu, Bi, Fe, Mo, W, As, Sn, Sb, Pb, B, Ge, In, Tl, Ru, Rh, Re, Os, Ir, Pt, Pd, Ag, Au, Co, Be, Mg, Ca, Sr, Ba, Mn, and rare earth elements. Note that, in the distortion resistance film 32, property such as a gauge factor, a temperature coefficient of sensitivity, and a temperature coefficient of resistance may change depending on the presence or absence of these trace elements and a heat treatment condition such as annealing.

A heat treatment temperature at the time of manufacturing the distortion resistance film 32 is not particularly limited, and may be, for example, 50°C to 550°C, and is preferably 350°C to 550°C.

As illustrated in Fig. 2, the electrode portion 36 is provided to overlap the distortion resistance film 32, and is electrically connected to the distortion resistance film 32. As illustrated in Fig. 2, the electrode portion 36 is formed on a part of an upper surface of the distortion resistance film 32. An output of the wheatstone bridge circuit included in the distortion resistance film 32 is transmitted to the circuit substrate 16 illustrated in Fig. 1 via the electrode portion 36 and the intermediate wiring 72. Examples of the material of the electrode portion 36 include a conductive metal or alloy, and more specifically include Cr, Ti, Ni, Mo, a platinum group element, and the like. Furthermore, the electrode portion 36 may have a multilayer structure including layers of different materials.

The base insulating layer 52 and the electrode portion 36 illustrated in Fig. 2 can also be formed by a thin film method such as sputtering or vapor deposition, similarly to the distortion resistance film 32. However, the base insulating layer 52 and the electrode portion 36 may be formed by a method other than the thin film method, and for example, the base insulating layer 52 made of a SiO₂ film may be provided on a Si substrate surface by heating the Si substrate surface to form a thermal oxide film.

Hereinafter, the distortion resistance film and the pressure sensor according to the present invention will be described in more detail with reference to Examples, but the present invention is not limited to only these Examples.

As examples, eight samples (Samples 1 to 8) having different amounts of each element were prepared for the distortion resistance film represented by Cr_{100-x-y-z}AlₓN_{y}Si_{z}. For each of the prepared samples, composition analysis, measurement of a gauge factor, measurement of a temperature coefficient of resistance (TCR), measurement of a temperature coefficient of sensitivity (TCS), a film peeling test, and measurement of an in-film stress were performed.

### Sample preparation

Fig. 3 is a schematic diagram illustrating a structure of the samples (Samples 1 to 8) prepared in Examples. In Example 1, the Si substrate 122 was heated to form a SiO₂ film 152, which was a thermal oxide film, on a surface of the Si substrate 122, and then a distortion resistance film 132 was formed on a surface of the SiO₂ film 152 using a DC sputtering device. Moreover, the distortion resistance film 132 after film formation was annealed (heat-treated) at 350°C, and then a resistor constituting a wheatstone bridge circuit was formed in the distortion resistance film 132 by microfabrication. Finally, an electrode layer was formed on a surface of the distortion resistance film 132 by electron vapor deposition to obtain a film measurement sample including the distortion resistance film 132 and a layered body 131 made of SiO₂.

In the film formation of the distortion resistance film 132 in each sample, eight samples having different amounts of each element were prepared by changing the number of Cr targets, Al targets, and Si targets used in the DC sputtering device and a potential of each target. The sputtering was performed in an atmosphere of Ar gas and a small amount of N gas. Furthermore, a film thickness of the distortion resistance film 132 was 300 nm.

### Composition analysis

For Samples 1 to 8, the composition of the distortion resistance film 132 was analyzed by an XRF (fluorescent X-ray) method.

### Measurement of temperature coefficient of resistance (TCR)

For each sample (Samples 1 to 8), a resistance value was measured while changing an environmental temperature from -50°C to 450°C, a relationship between the resistance value and the temperature for each sample was subjected to straight line approximation by a method of least squares to obtain a slope, and the TCR (ppm/°C) was calculated from the slope. A calculated reference temperature of the TCR is 25°C.

### Measurement of gauge factor and temperature coefficient of sensitivity TCS)

For each sample (Samples 1 to 8), the gauge factor (k-factor) was measured while changing the environmental temperature from -50°C to 450°C, a relationship between the gauge factor and the temperature for each sample was subjected to straight line approximation by the method of least squares to obtain a slope, and the TCS (ppm/°C) was calculated from the slope. A calculated reference temperature of TCS is 25°C. Note that the gauge factor shown in Table 1 is a measured value at 25°C as a reference temperature.

### Evaluation of film peeling

For each of Samples 1 to 8, 22 samples for measurement were prepared, and 100 cycles of a thermal shock test in which the sample was alternately moved between thermostatic baths at -50°C and 400°C were performed to evaluate the presence or absence of film peeling between the distortion resistance film 132 and the SiO₂ film 152 as a base insulating layer in each sample.

### Membrane stress

For Samples 1 to 8, the film stress of distortion resistance film 132 was measured for warpage due to the stress of the substrate by a step meter, and calculated from an amount of change in curvature radius.

Results of the composition analysis, the measurement of the gauge factor, the measurement of the temperature coefficient of resistance (TCR), the measurement of the temperature coefficient of sensitivity (TCS), the film peeling test, and the measurement of the in-film stress of each sample are shown in Table 1.

### [Table 1]

**Table 1**

| | Composition | | | | | Evaluation | | | | |
|---|---|---|---|---|---|---|---|---|---|---|
| Sample No. | General formula | Cr 100-x-y-z | Al X | N Y | Si Z | Gauge factor | TCR | TCS | Film peeling n/20 | Stress (MPa) |
| Sample 1 | Cr80.7Al14.2N5.1Si0 | 80.7 | 14.2 | 5.1 | 0 | 8 | -500 | 50 | 4 | 1506 |
| Sample 2 | Cr72.8Al26.1N1.0Si0.1 | 72.8 | 26.1 | 1 | 0.1 | 5 | -1750 | 172 | 0 | 814 |
| Sample 3 | Cr60.3Al30.2N9.4Si0.2 | 60.3 | 30.2 | 9.4 | 0.2 | 8 | -1760 | -135 | 0 | 794 |
| Sample 4 | Cr80.7Al14N5.0Si0.3 | 80.7 | 14 | 5 | 0.3 | 7 | -460 | 30 | 0 | 980 |
| Sample 5 | Cr55.5Al29.8N9.2Si5.5 | 55.5 | 29.8 | 9.2 | 5.5 | 5 | -1200 | -42 | 0 | 815 |
| Sampled | Cr64.3Al20.8N8.2Si6.7 | 64.3 | 20.8 | 8.2 | 6.7 | 6 | -1400 | 24 | 0 | 431 |
| Sample 7 | Cr48.0Al44.5N6.3Si1.2 | 48 | 44.5 | 6.3 | 1.2 | 4 | -1300 | 16 | 0 | 911 |
| Sample 8 | Cr60.7Al19.5N6.0Si13.8 | 60.7 | 19.5 | 6 | 13.8 | 3 | -1700 | -30 | 0 | 209 |

As shown in Table 1, in Samples 2 to 8 in which the distortion resistance film 132 contained Cr, Al, N, and Si, film peeling did not occur, and it was confirmed that the effect of preventing film peeling from the base insulating film was exhibited as compared with Sample 1 not containing Si. Furthermore, also from the measurement results of the film stress, it was confirmed from a stress state that in Samples 2 to 8 in which the distortion resistance film contained Cr, Al, N, and Si, a value of the stress was smaller than that in Sample 1 not containing Si, and the film peeling could be prevented.

Furthermore, when Samples 2 to 8 containing Si was relatively compared with each other, it was confirmed that Sample 2 to Sample 7 in which z indicating an amount of Si was 10 or less exhibited excellent detection sensitivity as the distortion resistance film 132 as compared with the case where the gauge factor was 4 or more and the gauge factor of Sample 8 in which z indicating the amount of Si exceeds 10 was 3. Furthermore, Samples 4 to 7 in which z indicating an amount of Si was 0.3 ≤ z ≤ 10 had a small absolute value of the TCR of 1500 or less as compared with Samples 2, 3, 7, and 8 in which z indicating the amount of Si was 0 < z < 0.3 or 10 < z, and exhibited good TCR property. Furthermore, in Samples 4 to 7 in which z indicating the amount of Si was 0.3 ≤ z ≤ 10, the absolute value of the TCS was also 100 or less, which was particularly favorable.

Although the pressure sensor 10 and the distortion resistance films 32 and 132 according to the present invention have been described above with reference to the embodiment and examples, the present invention is not limited only to these embodiment and examples. It goes without saying that the present invention includes many other embodiments and modified examples in addition to the above-described embodiment and examples. For example, the pressure sensor 10 is not limited to one having the stem 20 as illustrated in Fig. 1, and may be one produced by etching a substrate, or one produced by joining, to another material, a tabular substrate on which the distortion resistance film 32 or 132 is formed. A material of the substrate may be any of a metal, a semiconductor, and an insulator, and specific examples thereof include alumina (Al₂O₃) in addition to Si described in Examples.

### Reference Signs List

- 10: pressure sensor
- 12: connection member
- 12a: screw groove
- 12b: flow path
- 14: pressing member
- 16: circuit substrate
- 20: stem
- 21: flange portion
- 22: membrane
- 22a: inner surface
- 22b: outer surface
- 31, 131: layered body
- 32, 132: distortion resistance film
- 36: electrode portion
- 52: base insulating layer
- 72: intermediate wiring
- 152: SiO₂ film
- 122: Si substrate

## Claims

1. A distortion resistance film comprising an alloy material containing Cr, Al, N, and Si.

2. The distortion resistance film according to claim 1, wherein the ally material is represented by a formula Cr_{100-x-y-z}AlₓN_{y}Si_{z}, wherein composition regions of x, y, and z satisfy 5 ≤ x ≤ 50, 1 ≤ y ≤ 20, and 0 < z, respectively.

3. The distortion resistance film according to claim 1, wherein the ally material is represented by a formula Cr_{100-x-y-z}AlₓN_{y}Si_{z}, wherein composition regions of x, y, and z respectively satisfy 5 ≤ x ≤ 50, 1 ≤ y ≤ 20, and 0.3 ≤ z ≤ 10.

4. The distortion resistance film according to any one of claims 1 to 3, wherein O is contained in an amount of 10 at% or less with respect to a total amount of Cr, Al, N, and O.

5. The distortion resistance film according to any one of claims 1 to 4, wherein an absolute value of a temperature coefficient of sensitivity (TCS) is 2000 ppm/°C or less in a temperature range of -50°C or more and 400°C or less.

6. The distortion resistance film according to any one of claims 1 to 5, wherein an absolute value of a temperature coefficient of resistance (TCR) is 2000 ppm/°C or less in a temperature range of -50°C or more and 400°C or less.

7. A pressure sensor comprising:
the distortion resistance film according to any one of claims 1 to 6; and
an electrode portion electrically connected to the distortion resistance film.

8. A layered body comprising:
the distortion resistance film according to any one of claims 1 to 6; and
a base insulating layer that is in contact with the distortion resistance film and contains Si.
